# EUROPEAN PATENT SPECIFICATION

(11) **EP 4 395 489 B1**
(45) Date of publication and mention of the grant of the patent: **29.10.2025**
(21) Application number: 23810725.4
(22) Date of filing: 21.04.2023
(51) Int. Cl.: H05K 9/00, H05F 3/02, H04M 1/02

(54) **ELECTRONIC DEVICE**
ELEKTRONISCHE VORRICHTUNG
DISPOSITIF ÉLECTRONIQUE

(30) Priority: 27.05.2022 CN 202221316942 U
(43) Date of publication of application: 03.07.2024
(73) Proprietor: Honor Device Co., Ltd., Shenzhen, Guangdong 518040 (CN)
(72) Inventor: DONG, Xiaoyong, Shenzhen, Guangdong 518040 (CN)
(74) Representative: Isarpatent
(86) International application number: PCT/CN2023/089844
(87) International publication number: WO 2023/226652

(56) References cited:
- WO-A1-2004/062336
- WO-A1-2021/103975
- CN-A- 106 714 479
- CN-A- 113 079 685
- CN-B- 110 072 331
- CN-U- 210 986 876
- CN-U- 218 499 508
- US-A1- 2015 245 543
- US-A1- 2015 245 543

## Description

### TECHNICAL FIELD

This application relates to the field of communication technologies, and in particular, to an electronic device.

### BACKGROUND

An electronic element in an electronic device emits high-frequency electromagnetic waves during working. This causes interference to a normal operation of the electronic device, and in addition, the electromagnetic waves radiated to the outside also cause harm to a human body. To reduce the interference and radiation caused by the electromagnetic waves, a shielding can is usually used to cover an electronic element disposed on a circuit board to shield the electromagnetic waves radiated by the electronic element. In addition, to ensure that the circuit board works well, the circuit board needs to be electrically connected to a metal middle frame of the electronic device to implement grounding, thereby preventing static electricity and improving work stability.

In conventional technologies, the circuit board and the metal middle frame are electrically connected in the following manner. The shielding can is connected to the circuit board by soldering, and an elastic conductive member (such as a conductive foam, a conductive rubber, or a metal elastic piece) is tightly pressed and disposed between the shielding can and the metal middle frame. The elastic conductive member is configured with its own elastic force to be effectively in contact with the shielding can and the metal middle frame separately, thereby implementing electrical connection between the circuit board, the shielding can, the elastic conductive member, and the metal middle frame, so that the circuit board is grounded.

However, to arrange the elastic conductive member, a part of internal space of the electronic device needs to be occupied. This cannot meet a development trend of ultra-thinness of electronic devices. In addition, existence of the elastic conductive member also needs additional materials and processing costs, so that overall costs of the electronic device are increased.

CN 110 072 331 B discloses a shielding and grounding structure and a terminal device, wherein the shielding and grounding structure is used to electrically connect a printed circuit board and a metal frame, including a shielding and grounding unit; the shielding and grounding unit includes a shielding cover and a spring contact portion, the shielding cover and the spring contact portion being integrally molded; the shielding cover is used to connect to a printed circuit board, and the printed circuit board is electrically connected to the metal frame through the spring contact portion.

US 2015/245543 A1 discloses a fastening structure for a shield to shield a printed circuit board on which electronic components are mounted and the electronic components from electromagnetic waves includes a frame provided with a fixing part allowing the frame to be fixed to the printed circuit board, a shield cover provided to surround an outer side of the frame, fastening parts provided at the shield cover and the frame, respectively, such that the shield cover and the frame are attached/detached to/from each other.

WO 2004/062336 A1 discloses an electromagnetic shield structure in which an electromagnetic shield plate is so secured to a printed wiring board with a screw as to cover at least a part of the board.

### SUMMARY

This application provides an electronic device, as defined in the appended set of claims. A circuit board is securely connected to a middle frame by a fastener, and a shielding frame is sandwiched between the middle frame and the circuit board, so that the middle frame is directly electrically connected to the circuit board by the shielding frame to implement grounding. Therefore, there is no need to use an elastic conductive member, and there is no need to consider accommodation space of the elastic conductive member, to enable the electronic device to meet a design requirement of ultra-thinness, and reduce material and processing costs of the electronic device.

This application provides an electronic device, including a circuit board, a shielding frame, and a middle frame.

The circuit board is provided with an electronic element.

The shielding frame is disposed on the circuit board, and surrounds the electronic element.

The middle frame is securely connected to the circuit board by a fastener, and the shielding frame is sandwiched between the middle frame and the circuit board, to enable the middle frame, the shielding frame, and the circuit board to be electrically connected.

According to the electronic device provided in this application, the circuit board is securely connected to the middle frame, and the shielding frame is sandwiched between the middle frame and the circuit board, so that the middle frame is directly electrically connected to the circuit board by the shielding frame to implement grounding. Therefore, there is no need to use an elastic conductive member. This avoids considering accommodation space of the elastic conductive member in a structural design phase, to enable the electronic device to meet a design requirement of ultra-thinness. In addition, the electronic device provided in this application does not need additional elastic conductive members such as a conductive foam, a conductive rubber, and a metal elastic piece. This can reduce purchasing and processing costs of the elastic conductive members, thereby reducing overall production costs of the electronic device.

According to the electronic device provided in this application, because the accommodation space of the elastic conductive member is reduced, a size requirement for the internal space of the electronic device is lowered, so that the electronic device can meet the design requirement of ultra-thinness. Alternatively, without changing a thickness of the electronic device, the accommodation space reduced by the elastic conductive member can be provided for another functional element, so that a structural design of the electronic device is more flexible and diverse, thereby facilitating structural optimization.

According to the electronic device provided in this application, static electricity of the circuit board may be discharged through a path formed by the shielding frame and the middle frame. This can ensure that the static electricity of the circuit board is not accumulated, thereby avoiding affecting circuits and electronic elements. In addition, when the electronic element radiates and couples an electromagnetic signal by using the circuit board to the shielding frame, the shielding frame may conduct the electromagnetic signal to the middle frame, so that a residual electromagnetic signal that is parasitic on the shielding frame is reduced, and electromagnetic interference to an external electronic element and another component is further reduced.

In a possible design, the fastener sequentially passes through the middle frame and the shielding frame, and is connected to the circuit board.

In a possible design, the fastener includes a bolt and nut assembly, a pin assembly, or a screw.

In a possible design, the fastener includes a screw. A first hole is formed in the circuit board. The middle frame has a protrusion formed by the middle frame extending toward the circuit board. A second hole having a hole wall provided with an internal thread is formed in a surface of the protrusion. The screw passes through the first hole and is screwed into the second hole, to enable the middle frame to be securely connected to the circuit board.

In a possible design, the electronic device further includes:
a shielding cover, where the shielding cover is located between the middle frame and the shielding frame. The shielding cover has a first raised housing bending toward the circuit board. A cavity of the first raised housing is configured to accommodate the protrusion. A third hole is formed in a top wall of the first raised housing. The screw sequentially passes through the first hole and the third hole, and is screwed into the second hole, to enable the protrusion, the first raised housing, and the circuit board to be sequentially abut against each other.

In a possible design, the shielding frame has a second raised housing formed by the shielding frame bending toward the circuit board. A cavity of the second raised housing may accommodate the first raised housing. A fourth hole is formed in a top wall of the second raised housing. The screw sequentially passes through the first hole, the fourth hole, and the third hole, and is screwed into the second hole, to enable the protrusion, the first raised housing, the second raised housing, and the circuit board to be sequentially abut against each other.

In a possible design, the electronic device further includes:
a pad portion, disposed between a head of the screw and the circuit board.

In a possible design, the pad portion includes a base and a bracket. A fifth hole is formed in the base and is located in a limiting groove formed in the bracket. The screw sequentially passes through the fifth hole, the first hole, the fourth hole, and the third hole, and is screwed into the second hole, to enable the protrusion, the first raised housing, the second raised housing, the circuit board, and the base to be sequentially abut against each other.

In a possible design, a plurality of contact points for abutting are provided on at least one of the surface of the protrusion, the top wall of the first raised housing, and the top wall of the second raised housing.

In a possible design, a crack arrest groove for stress relief is provided in an area on the shielding cover adjacent to the third hole and/or an area on the shielding frame adjacent to the fourth hole.

In a possible design, the shielding cover detachably covers the shielding frame.

In a possible design, a flange of the shielding cover has bosses arranged at intervals. Snap holes are formed in peripheral walls of the shielding frame corresponding to the bosses. The bosses may be snapped into the snap holes, to enable the shielding cover to be connected to the shielding frame.

In a possible design, the electronic device is a phone, a tablet computer, a portable multimedia player, or a handheld game console.

In a possible design, the circuit board is a main board. The electronic element includes a central processing unit, a storage module, a power supply module, and a wireless communication module. The shielding frame surrounds the central processing unit, the storage module, the power supply module, and the wireless communication module.

### BRIEF DESCRIPTION OF DRAWINGS

FIG. 1 is a schematic diagram of an example of an electronic device according to an embodiment of this application;
FIG. 2 is an exploded view of the electronic device in FIG. 1;
FIG. 3 is a schematic partial view of a circuit board, a shielding frame, a shielding cover, a middle frame, and a pad portion in FIG. 1;
FIG. 4 is an exploded view of the circuit board, the shielding frame, the shielding cover, the middle frame, and the pad portion in FIG. 3;
FIG. 5 is a sectional view along A-A in FIG. 3;
FIG. 6 is an exploded view of another example of the circuit board, the shielding frame, the shielding cover, the middle frame, and the pad portion in FIG. 3;
FIG. 7 is a sectional view along A-A of another example in FIG. 3;
FIG. 8 is a schematic diagram of an example of a shielding frame according to an embodiment of this application;
FIG. 9 is a schematic diagram of an example of a shielding cover according to an embodiment of this application;
FIG. 10 is a schematic diagram of another example of a shielding cover and a shielding frame according to an embodiment of this application; and
FIG. 11 is an enlarged view of section B in FIG. 10.

Reference numerals:
10: circuit board; 11: electronic element; 12: first hole; 21: shielding frame; 211: second raised housing; 212: fourth hole; 213: hollow region; 214: snap hole; 22: shielding cover; 221: first raised housing; 222: third hole; 223: crack arrest groove; 224: boss; 30: middle frame; 31: protrusion; 32: second hole; 33: contact point; 40: pad portion; 41: fifth hole; 42: base; 43: bracket; 431: limiting groove; 50: fastener; 60: display screen assembly; 70: housing; 100: electronic device.

### DESCRIPTION OF EMBODIMENTS

The following describes an example of possible related content in embodiments of this application. Apparently, the described embodiments are merely some embodiments rather than all embodiments of this application.

In the descriptions of this application, it should be noted that unless otherwise explicitly specified or defined, the terms such as "install", "connect", and "connection" should be understood in a broad sense. For example, the connection may be a fixed connection, a detachable connection, or an integral connection; the connection may be a mechanical connection or an electrical connection or may communicate with each other; or the connection may be a direct connection, an indirect connection through an intermediate medium, internal communication between two components, or an interaction relationship between two components. A person of ordinary skill in the art may understand the specific meanings of the foregoing terms in this application according to specific situations.

In the description of this application, it should be understood that an orientation or a position relationship indicated by the terms "above", "below", "side", "inner", "outer", "top", "bottom", and the like is an orientation or a position relationship based on installation, and is merely intended for ease of describing this application and simplifying description, but does not indicate or imply that a described apparatus or element needs to have a specific orientation and be constructed and operated in a specific orientation. Therefore, such terms shall not be understood as a limitation on this application.

It should be further noted that a same reference numeral in embodiments of this application represents a same part or a same component. For a same component in embodiments of this application, only one part or component may be used as an example to mark a reference numeral in the figures. It should be understood that, for another same part or component, the reference numeral is also applicable.

In the descriptions of this application, it should be noted that the term "and/or" is merely an association relationship for describing associated objects and represents that three relationships may exist. For example, A and/or B may represent the following three cases: Only A exists, both A and B exist, and only B exists.

Electronic elements are basic elements in electronic circuits. After being connected to each other, electronic elements may constitute an electronic circuit with a specific function. An electronic element may be an individual package, such as a resistor, a capacitor, an inductor, a transistor, or a diode, or may be various groups with different complexity, for example, an integrated circuit, such as a central processing unit, a storage module, a power supply module, and a wireless communication module.

The electronic element emits high-frequency electromagnetic waves during working. The electronic element is not expected to be interfered with by external electromagnetic waves. In addition, electromagnetic waves of the electronic element are not expected to interfere with an external device and cause radiation harm to a human body, so that a propagation path of the electromagnetic waves needs to be blocked. Currently, a shielding can is usually used to cover an electronic element disposed on a circuit board to shield the electromagnetic waves radiated by the electronic element.

Currently, a metal material is generally used in a middle frame of an electronic device in a market, especially in smartphones. The middle frame made of a metal material has good processing accuracy and durability. When the middle frame is used in the electronic device, a quality of a product and a grade of the electronic device can be improved. A circuit board on the electronic device is very easy to accumulate static electricity. This is very unfavorable for working of the circuit board and the entire electronic device. When an electronic element of the circuit board is provided with static electricity, a generated electrostatic discharge (Electrostatic discharge, ESD) breaks down and damages the electronic element on the circuit board, so that a normal operation of the circuit board is affected. Therefore, to ensure that the circuit board works well, the circuit board needs to be electrically connected to a metal middle frame of the electronic device to implement grounding, thereby preventing static electricity and improving work stability.

In conventional technologies, the circuit board and the metal middle frame are electrically connected in the following manner. The shielding can is connected to the circuit board by soldering, and an elastic conductive member, such as a conductive foam, a conductive rubber, or a metal elastic piece, is tightly pressed and disposed between the shielding can and the metal middle frame. The elastic conductive member is configured with its own elastic force to be effectively in contact with the shielding can and the metal middle frame separately, thereby implementing electrical connection between the circuit board, the shielding can, the elastic conductive member, and the metal middle frame, so that the circuit board is grounded.

When the elastic conductive member is used to implement grounding of the circuit board, a separate area needs to be occupied. This causes reduced space utilization of the electronic device. With a development trend of ultra-thinness of the electronic device, an internal structure of the electronic device cannot provide sufficient accommodation space for the elastic conductive member. In addition, existence of the elastic conductive member also needs additional material and processing costs, so that overall costs of the electronic device are increased.

To sum up, currently, a manner in which the circuit board is electrically connected to the metal middle frame by the elastic conductive member has disadvantages, for example, occupying large internal space of a device and high material and processing costs.

Therefore, to resolve the foregoing technical problems, this application provides an electronic device. A circuit board is securely connected to a middle frame by a fastener, and a shielding frame is sandwiched between the middle frame and the circuit board, so that the middle frame is directly electrically connected to the circuit board by the shielding frame to implement grounding. Therefore, there is no need to use an elastic conductive member, and there is no need to consider accommodation space of the elastic conductive member, to enable the electronic device to meet a design requirement of ultra-thinness, and reduce material and processing costs of the electronic device.

The electronic device in this application is a device that includes a plurality of types of electronic elements such as an integrated circuit, a transistor, and an electronic tube, and uses electronic technology software to function, for example, a desktop computer, a notebook computer, a tablet computer, a game console, a phone, a router, a set-top box, a television, a navigation device, a modem, or a multimedia player, or may be a small device, for example, a wristwatch device, a pendant device, an earphone, an earpiece device, a device embedded in glasses, another device worn on a head of a user, or another wearable or micro device.

The electronic device provided in this application are described in detail with reference to the accompanying drawings.

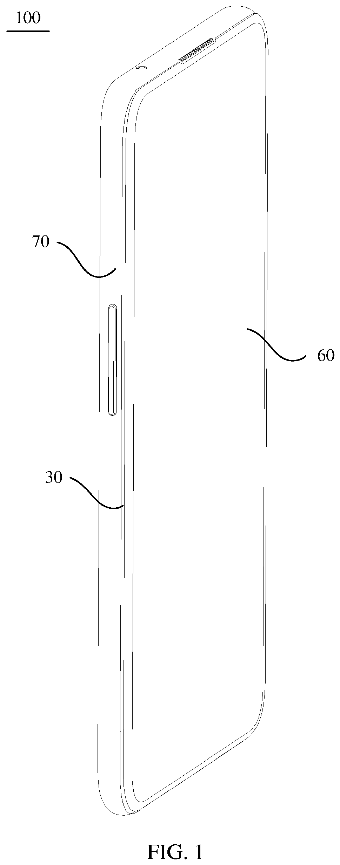

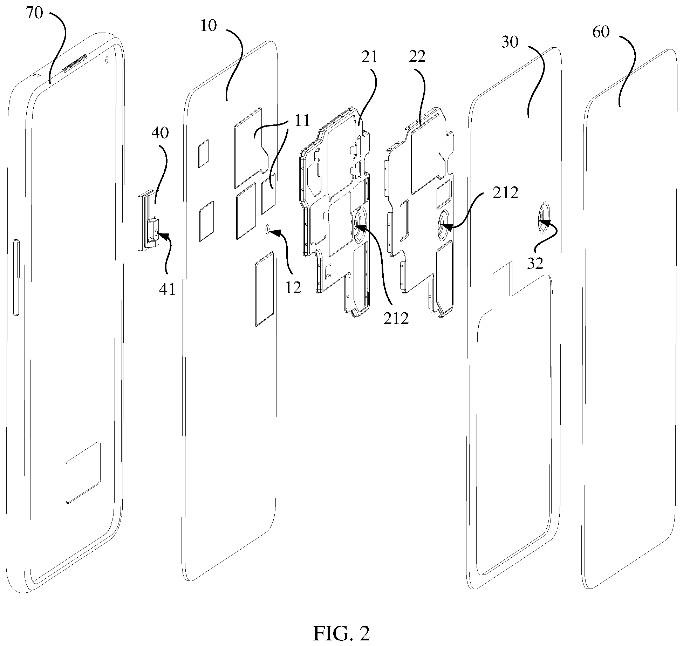

FIG. 1 is a schematic diagram of an example of an electronic device 100 according to an embodiment of this application. FIG. 2 is an exploded view of the electronic device 100 in FIG. 1.

As shown in FIG. 1 and FIG. 2, an embodiment of this application provides an electronic device 100, including a display screen assembly 60, a housing 70, a circuit board 10, a shielding frame 21, and a middle frame 30. The display screen assembly 60 and the middle frame 30 are stacked and cover the housing 70. The circuit board 10, the shielding frame 21, a battery, another functional component, and a support are disposed in an inner cavity of the housing 70.

The circuit board 10 is provided with an electronic element 11. The circuit board 10 is provided with one or more electronic elements 11. The electronic elements 11 and the circuit board 10 may be connected by a wire or in a surface-mounted manner, thereby implementing integration of the electronic elements 11 and the circuit board 10.

The shielding frame 21 is disposed on the circuit board 10 and connected to the circuit board 10, and the shielding frame 21 surrounds the electronic element 11. The shielding frame 21 surrounds outside of an electronic element 11 or a plurality of electronic elements 11. For example, a shielding frame 21 may surround outside of an electronic element 11, or a shielding frame 21 may alternatively surround outside of four electronic elements 11 simultaneously.

The middle frame 30 is securely connected to the circuit board 10 by a fastener 50, and the shielding frame 21 is sandwiched between the middle frame 30 and the circuit board 10, so that the middle frame 30 is electrically connected to the circuit board 10 by the shielding frame 21. The middle frame 30 is a part of the housing 70 assembly of the electronic device 100. The middle frame 30 includes two opposite side surfaces. The display screen assembly 60 is disposed on a front side surface, and components, for example, the circuit board 10 and the battery, are disposed on a rear side surface. Then, the front side surface is connected to the display screen assembly 60, and the rear side surface is connected to the housing 70, to form a main body of the electronic device 100. The middle frame 30 abuts against and is connected to the shielding frame 21, so that the middle frame 30 is electrically connected to the circuit board 10 by the shielding frame 21, to implement grounding of the circuit board 10.

The middle frame 30 may be entirely made of a metal material, or may be partially made of a metal material. For example, an area connected to the shielding frame 21 and an area exposed to the outside are made of a metal material. In other words, the area of the middle frame 30, which is made of a metal material, should meet the requirement of being able to discharge static electricity of the circuit board 10 to the external environment. The metal material may be stainless steel, magnesium aluminum alloy, or the like. It should be noted that a material of the middle frame 30 includes but is not limited to the foregoing materials.

According to the electronic device 100 provided in this embodiment of this application, the circuit board 10 is securely connected to the middle frame 30, and the shielding frame 21 is sandwiched between the middle frame 30 and the circuit board 10, so that the middle frame is 30 directly electrically connected to the circuit board 10 by the shielding frame 21 to implement grounding. Therefore, there is no need to use an elastic conductive member. This avoids considering accommodation space of the elastic conductive member in a structural design phase, to enable the electronic device 100 to meet a design requirement of ultra-thinness. In addition, the electronic device 100 provided in this embodiment of this application does not need additional elastic conductive members such as a conductive foam, a conductive rubber, and a metal elastic piece. Therefore, purchasing and processing costs of the elastic conductive members can be reduced, thereby reducing overall production costs of the electronic device 100.

According to the electronic device 100 provided in this embodiment of this application, because the accommodation space of the elastic conductive member is reduced, a size requirement for the internal space of the electronic device 100 is lowered, so that the electronic device 100 can meet the design requirement of ultra-thinness. Alternatively, without changing a thickness of the electronic device 100, the accommodation space reduced by the elastic conductive member can be provided for another functional element, so that a structural design of the electronic device 100 is more flexible and diverse, thereby facilitating structural optimization.

According to the electronic device 100 provided in this embodiment of this application, static electricity of the circuit board 10 may be discharged through a path formed by the shielding frame 21 and the middle frame 30, to ensure that the static electricity of the circuit board 10 is not accumulated, thereby avoiding affecting circuits and electronic elements 11. In addition, when the electronic element 11 radiates and couples an electromagnetic signal by using the circuit board 10 to the shielding frame 21, the shielding frame 21 may conduct the electromagnetic signal to the middle frame 30, so that a residual electromagnetic signal that is parasitic on the shielding frame 21 is reduced, and electromagnetic interference to an external electronic element 11 and another component is further reduced.

Optionally, there are a plurality of manners of arranging the shielding frame 21 on the circuit board 10. The shielding frame 21 may be fixed with the circuit board 10 by welding. Alternatively, the shielding frame 21 may be directly sandwiched between the middle frame 30 and the circuit board 10 and abut against the circuit board 10, but not be welded onto the circuit board 10.

Optionally, the shielding frame 21 is made of a metal material, for example, stainless steel, copper-nickel-zinc alloy, or magnesium aluminum alloy.

Optionally, copper foil or aluminum foil may be laid on the shielding frame 21 to form an enclosed structure in the shielding frame 21, so that electromagnetic interference can be eliminated and harm to a human body caused by electromagnetic waves is isolated.

Optionally, a shielding cover 22 may cover the shielding frame 21. For details, refer to embodiments below.

Optionally, the copper foil or the aluminum foil may not be laid on the shielding frame 21, and the shielding cover 22 may not cover the shielding frame 21. Instead, the middle frame 30 covers the shielding frame 21 to form an enclosed structure in the shielding frame 21. In other words, the shielding frame 21 surrounds the electronic element 11, and is fixed with the circuit board 10 by welding. The middle frame 30 is used to cover the shielding frame 21, and the middle frame 30 is securely connected to the circuit board 10, so that the middle frame 30 tightly covers the shielding frame 21. The electronic element 11 is enclosed in the enclosed structure formed by the shielding frame 21 and the middle frame 30, thereby reducing radiation leakage and meeting a shielding function of the shielding frame 21. The enclosed structure formed by the shielding frame 21 and the middle frame 30 shields the electronic element 11, so that the shielding cover 22, copper foil, or aluminum foil does not need to be added, and material and processing production costs of the shielding cover 22, copper foil, or aluminum foil can be reduced.

Optionally, the circuit board 10 is securely connected to the middle frame 30, or may be securely connected to the middle frame 30 by an insertion structure or a hook structure. Specifically, the hook structure includes an elastic hook portion and a slot. The hook portion is provided on one of the circuit board 10 and the middle frame 30, and the slot is correspondingly formed in the other of the circuit board 10 and the middle frame 30. During assembly and connection, the circuit board 10 and the middle frame 30 are aligned with each other, with the shielding frame 21 serving as a spacer therebetween. The hook portion is aligned with the slot and is pressed, and the hook portion is elastically deformed and inserted into the slot. In a vertical direction, the hook portion is hooked to an opening of the slot to prevent separation of the circuit board 10 from the middle frame 30. In addition, the shielding frame 21 forms a supporting spacing between the circuit board 10 and the middle frame 30, and the circuit board 10 and the middle frame 30 cannot move toward each other. In a horizontal direction, a root of the hook portion cooperates with the slot to play a limiting role, thereby avoiding laterally moving the circuit board 10 relative to the middle frame 30.

Optionally, the fastener 50 may include a bolt and a nut. The bolt is screwed into the nut after sequentially passing through a through hole formed in the circuit board 10 and that formed in the middle frame 30, so that the circuit board 10 is securely connected to the middle frame 30.

Optionally, the fastener 50 may include a pin assembly. Specifically, the pin assembly includes a hole pin and a cotter pin. After one end with a hole of the hole pin sequentially passes through the through holes formed in the circuit board 10 and the middle frame 30, the cotter pin is inserted into the hole of the hole pin, and the cotter pin is spread out, so that the middle frame 30 is securely connected to the circuit board 10.

Optionally, the fastener 50 may include a screw. A threaded hole is formed in the middle frame 30. The screw passes through a through hole formed in the circuit board 10 and is locked with the threaded hole, so that the middle frame 30 is securely connected to the circuit board 10 by the screw. For details, refer to embodiments below.

Optionally, after the fastener 50 avoids the shielding frame 21, the middle frame 30 may be securely connected to the circuit board 10 by the fastener 50.

Specifically, there may be a plurality of fasteners 50 distributed around the shielding frame 21. After the fasteners 50 avoid the shielding frame 21, the middle frame 30 is securely connected to the circuit board 10 by the fasteners 50.

In an embodiment, the fastener 50 sequentially passes through the middle frame 30 and the shielding frame 21, and is connected to the circuit board 10.

As described above, after the fastener 50 avoids the shielding frame 21, the middle frame 30 may be securely connected to the circuit board 10 by the fastener 50. However, a plurality of fasteners 50 need to be disposed and distributed around the shielding frame 21. This enables a force of sandwiching by the middle frame 30 and the circuit board 10 to be evenly applied to the shielding frame 21, and in addition, this can ensure that the middle frame 30 and the circuit board 10 can be balanced after being fastened, to maintain stable connection.

In this embodiment, the fastener 50 sequentially passes through the middle frame 30 and the shielding frame 21, and is connected to the circuit board 10, so that a connection point of the middle frame 30 and the circuit board 10 may be at the center of the shielding frame 21. This makes it easier to ensure that the middle frame 30 and the circuit board 10 can be balanced after being fastened, to maintain stable connection. The plurality of fasteners 50 does not need to be disposed and distributed around the shielding frame 21, so that one or a small quantity of fasteners 50 are needed.

Therefore, the fastener 50 in this embodiment is disposed through the shielding frame 21. One or a small quantity of fasteners 50 are needed to ensure that the middle frame 30 and the circuit board 10 can be balanced after fastening, to maintain stable connection, with advantages of low material costs and easy assembly.

Optionally, when passing through the shielding frame 21, the fastener 50 may pass through a hollow region 213 on the shielding frame 21, or an avoiding hole for avoiding the fastener 50 is specially formed in the shielding frame 21.

In an embodiment, the fastener 50 includes a screw. A first hole 12 is formed in the circuit board 10. The middle frame 30 has a protrusion 31 extending toward the circuit board 10. A second hole 32 having a hole wall provided with an internal thread is formed in a surface of the protrusion 31. The screw passes through the first hole 12 and is screwed into the second hole 32, to enable the middle frame 30 to be securely connected to the circuit board 10.

As described above, the fastener 50 may only include the screw. In other words, in the technical solution in this embodiment, the first hole 12 is formed in the circuit board 10. The middle frame 30 has the protrusion 31 extending toward the circuit board 10. The second hole 32 having a hole wall provided with an internal thread is formed in the surface of the protrusion 31. The screw passes through the first hole 12 and is screwed into the second hole 32, to enable the middle frame 30 to be securely connected to the circuit board 10.

In comparison with the bolt and nut assembly or the pin assembly, the screw is used as the fastener 50 in this embodiment, with an advantage of simple and fast assembly. This can reduce assembly steps of the electronic device 100, and can improve assembly efficiency. In addition, the second hole 32 with the internal thread is preformed in the middle frame 30, and the second hole 32 is located at the protrusion 31, so that the second hole 32 has a sufficient thread screwing length, to ensure connection reliability of the screw, and to ensure connection strength between the middle frame 30 and the circuit board 10.

In this embodiment, a manner of secure connection between the middle frame 30 and the circuit board 10 is specifically limited. The connection strength between the middle frame 30 and the circuit board 10 can be strengthened by the screw, so that the shielding frame 21 tightly abuts against between the middle frame 30 and the circuit board 10, to ensure that the circuit board 10, the shielding frame 21, and the middle frame 30 are in full contact, thereby ensuring an electrical connection relationship between the circuit board 10, the shielding frame 21, and the middle frame 30.

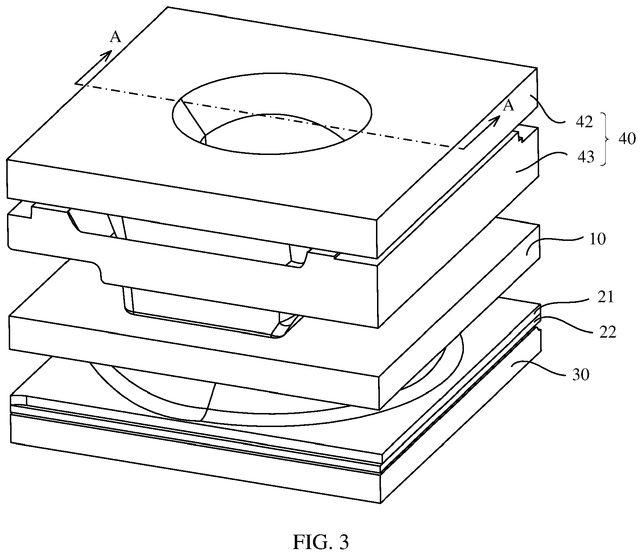

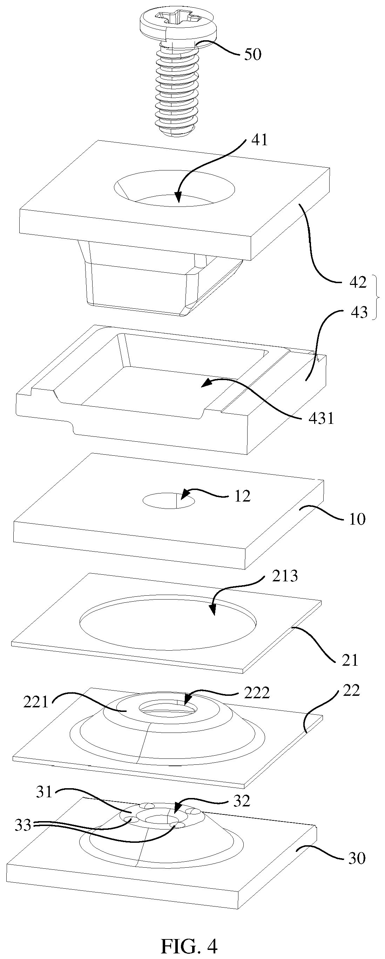

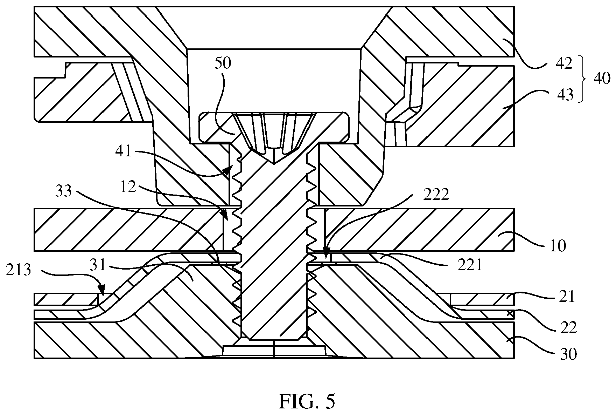

FIG. 3 is a schematic partial view of the circuit board 10, the shielding frame 21, the shielding cover 22, the middle frame 30, and a pad portion 40 in FIG. 1. FIG. 4 is an exploded view of the circuit board 10, the shielding frame 21, the shielding cover 22, the middle frame 30, and the pad portion 40 in FIG. 3. FIG. 5 is a sectional view along A-A in FIG. 3.

As shown in FIG. 3 to FIG. 5, in an embodiment, the electronic device 100 further includes a shielding cover 22 located between the middle frame 30 and the shielding frame 21. The shielding cover 22 has a first raised housing 221 bending toward the circuit board 10. A cavity of the first raised housing 221 may accommodate the protrusion 31. A third hole 222 is formed in a top wall of the first raised housing 221. The screw sequentially passes through the first hole 12 and the third hole 222, and is screwed into the second hole 32, to enable the protrusion 31, the first raised housing 221, and the circuit board 10 to be sequentially abut against each other.

As described above, the shielding cover 22 may cover the shielding frame 21. In other words, in the technical solution in this embodiment, the shielding cover 22 cooperates with the shielding frame 21 to enclose the electronic element 11, thereby ensuring shielding reliability. In addition, the shielding cover 22 has a first raised housing 221 bending toward the circuit board 10. The shielding frame 21 has a hollow region 213 for avoiding the first raised housing 221. The cavity of the first raised housing 221 may accommodate the protrusion 31. The third hole 222 is formed in the top wall of the first raised housing 221. The screw sequentially passes through the first hole 12 and the third hole 222, and is screwed into the second hole 32, to enable the protrusion 31, the first raised housing 221, and the circuit board 10 to be sequentially abut against each other. In addition, the shielding frame 21 is also abutted against and sandwiched between the shielding cover 22 and the circuit board 10, thereby implementing an electrical connection relationship between the circuit board 10, the shielding frame 21, the shielding cover 22, and the middle frame 30.

In this embodiment, only one screw may be disposed to pass through the middle of the circuit board 10, the shielding cover 22, and the middle frame 30. When secure connection strength is ensured, a quantity of used fasteners 50 may be reduced as much as possible, assembly steps of the electronic device 100 are further reduced, and assembly efficiency is improved.

In this embodiment, shapes and heights of the protrusion 31 and the first raised housing 221 may be adjusted based on a specific condition of the shielding frame 21, to ensure that the protrusion 31, the first raised housing 221, and the circuit board 10 abut against each other well, thereby achieving an objective of reliable grounding of the circuit board 10.

Optionally, the first raised housing 221 on the shielding cover 22 is formed in a stamping manner.

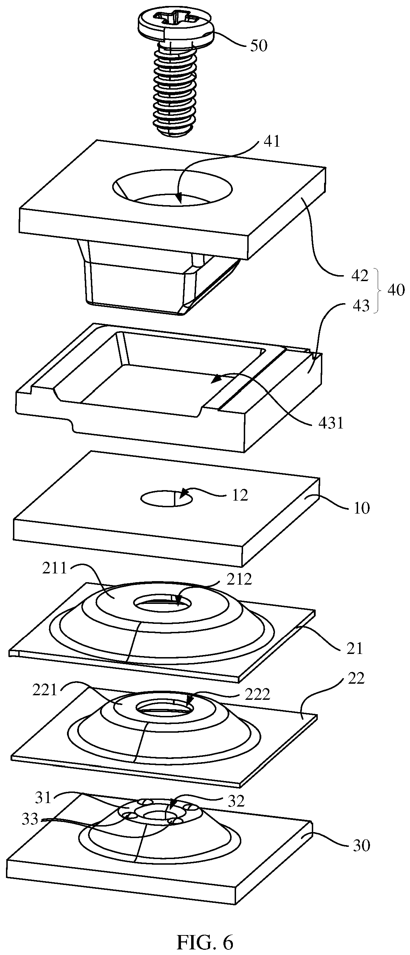

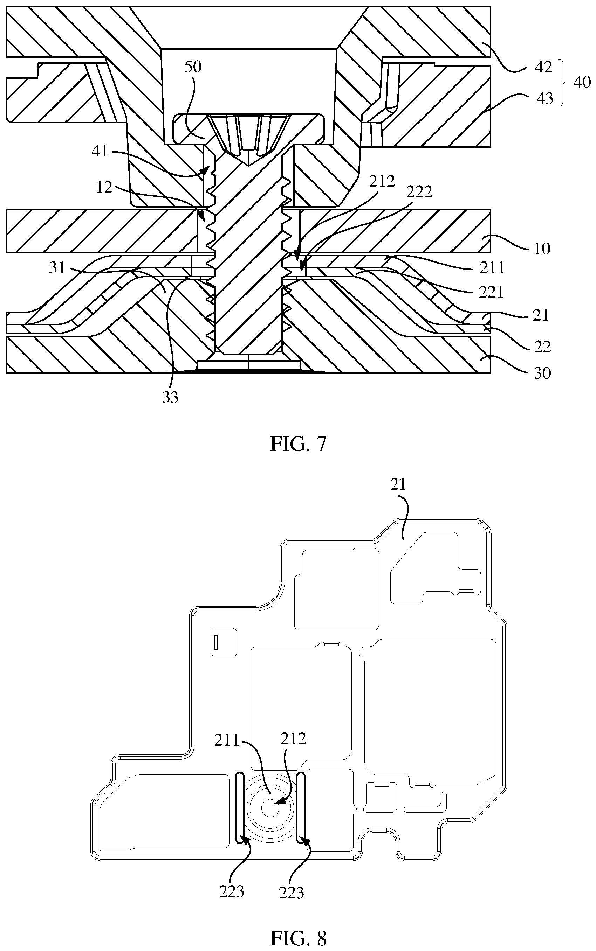

FIG. 6 is an exploded view of another example of the circuit board 10, the shielding frame 21, the shielding cover 22, the middle frame 30, and the pad portion 40 in FIG. 3. FIG. 7 is a sectional view along A-A of another example in FIG. 3.

As shown in FIG. 6 and FIG. 7, in an embodiment, the shielding frame 21 has a second raised housing 211 formed by the shielding frame 21 bending toward the circuit board 10. A cavity of the second raised housing 211 may accommodate the first raised housing 211. A fourth hole 212 is formed in a top wall of the second raised housing 211. The screw sequentially passes through the first hole 12, the fourth hole 212, and the third hole 222, and is screwed into the second hole 32, to enable the protrusion 31, the first raised housing 221, the second raised housing 221, and the circuit board 10 to be sequentially abut against each other.

In the foregoing embodiments, the shielding frame 21 is mainly fixed in a manner in which the shielding frame 21 is sandwiched and fixed between the middle frame 30 and the circuit board 10. In this embodiment, to further enhance connection reliability between the shielding frame 21 and the circuit board 10, the shielding frame 21 is also locked by the screw. Specifically, the shielding frame 21 has a second raised housing 211 formed by the shielding frame 21 bending toward the circuit board 10. The cavity of the second raised housing 211 may accommodate the first raised housing 221. The fourth hole 212 is formed in the top wall of the second raised housing 211. The screw sequentially passes through the first hole 12, the fourth hole 212, and the third hole 222, and is screwed into the second hole 32, to enable the protrusion 31, the first raised housing 221, the second raised housing 211, and the circuit board 10 to be sequentially abut against each other, thereby implementing electrical connection between the circuit board 10, the shielding frame 21, the shielding cover 22, and the middle frame 30.

In this embodiment, a connection effect between the circuit board 10, the shielding frame 21, the shielding cover 22, and the middle frame 30 is strengthened, so that the circuit board 10, the shielding frame 21, the shielding cover 22, and the middle frame 30 are all fastened together by the screw. In this way, an entire grounding structure has good seismic resistance, and a drop test before leaving a factory can be met. In addition, in a more complex user usage condition, the electrical connection relationship between the circuit board 10 and the middle frame 30 through the shielding frame 21 and the shielding cover 22 can be ensured even under severe vibration.

Optionally, the second raised housing 211 on the shielding frame 21 is formed in a stamping manner.

Optionally, an annular peripheral wall is formed by stamping and stretching the shielding frame 21. A flat surface of the peripheral wall is a same flat surface as a top surface of the second raised housing 211. The peripheral wall of the shielding frame 21 and the second raised housing 211 may be welded onto the circuit board 10 by soldering.

Optionally, the peripheral wall of the shielding frame 21 is welded onto the circuit board 10 by soldering, and the second raised housing 211 may be directly pressed and abut against the circuit board 10 without being welded.

As shown in FIG. 2 to FIG. 7, in an embodiment, the electronic device 100 further includes: a pad portion 40, disposed between a head of the screw and the circuit board 10, to prevent causing damage to the circuit board 10 by the head of the screw during a fastening process.

The circuit board 10 and the middle frame 30 are directly pressed together by the screw. This is easy to cause damage to the circuit board 10 by the head of the screw. Therefore, in this embodiment, the pad portion 40 is additionally provided. The pad portion 40 is disposed between the head of the screw and the circuit board 10, to prevent causing damage to the circuit board 10 by the head of the screw during the fastening process.

In this embodiment, the pad portion 40 is additionally provided between the head of the screw and the circuit board 10, so that the head of the screw does not directly contact the circuit board 10, thereby avoiding rubbing against the circuit board 10 by the head of the screw when the screw is screwed. This effectively prevents causing damage to the electronic element 11 or circuits on the circuit board 10, and ensures a yield rate of a product.

Optionally, the pad portion 40 may be a cushion additional that is additionally provided. The cushion is made of a flexible material.

Optionally, the pad portion 40 may alternatively be an original component inside the electronic device 100. For example, the pad portion 40 is a support for supporting the circuit board 10.

As shown in FIG. 2 to FIG. 7, in an embodiment, the pad portion 40 includes a base 42 and a bracket 43. A fifth hole 41 is formed in the base 42 and is located in a limiting groove 431 formed in the bracket 43. The screw sequentially passes through the fifth hole 41, the first hole 12, the fourth hole 212, and the third hole 222, and is screwed into the second hole 32, to enable the protrusion 31, the first raised housing 221, the second raised housing 211, the circuit board 10, and the base 42 to be sequentially abut against each other.

As described above, the pad portion 40 may be a support used for supporting the circuit board 10. In the technical solution in this embodiment, the pad portion 40 includes the base 42 and the bracket 43. The fifth hole 41 is formed in the base 42 and is located in the limiting groove 431 formed in the bracket 43. The screw sequentially passes through the fifth hole 41, the first hole 12, the fourth hole 212, and the third hole 222, and is screwed into the second hole 32, to enable the protrusion 31, the first raised housing 221, the second raised housing 211, the circuit board 10, and the base 42 to be sequentially abut against each other. The base 42 mainly serves to avoid contact between the screw and the circuit board 10. The bracket 43 is connected to the housing 70 to support the base 42 and the circuit board 10.

As shown in FIG. 6 and FIG. 7, in an embodiment, a plurality of contact points 33 for abutting are provided on at least one of the surface of the protrusion 31, the top wall of the first raised housing 221, and the top wall of the second raised housing 211.

Theoretically speaking, the circuit board 10, the surface of the protrusion 31, the top wall of the first raised housing 221, and the top wall of the second raised housing 211 are all flat-plate structures. The screw sequentially passes through the first hole 12, the fourth hole 212, and the third hole 222, and is screwed into the second hole 32. This can ensure that the protrusion 31, the first raised housing 221, the second raised housing 211, and the circuit board 10 sequentially abut against each other, thereby implementing electrical connection between the circuit board 10, the shielding frame 21, the shielding cover 22, and the middle frame 30. However, during a process of actual production processing, it was found that there is a dimensional tolerance in any component that cannot be eliminated. A result that the dimensional tolerance exists in the surface of the protrusion 31, the top wall of the first raised housing 221, and the top wall of the second raised housing 211 is that a surface used for abutting and contact is slightly uneven, and full abutting and contact cannot be guaranteed.

Therefore, to resolve the foregoing problems, in this embodiment, the plurality of contact points 33 for abutting are provided on at least one of the surface of the protrusion 31, the top wall of the first raised housing 221, the top wall of the second raised housing 211. Under a screwing force of the screw, the protrusion 31 is displaced relative to the circuit board 10, and the first raised housing 221 and the second raised housing 211 are sandwiched and in close contact with each other by the contacts 33. Even if the circuit board 10, the surface of the protrusion 31, the top wall of the first raised housing 221, and the top wall of the second raised housing 211 are slightly uneven, the circuit board 10, the protrusion 31, and the first raised housing 221, and the second raised housing 211 may be in close contact with each other by the contacts 33, thereby ensuring electrical connection between the circuit board 10, the shielding frame 21, the shielding cover 22, and the middle frame 30.

In this embodiment, the plurality of contact points 33 for abutting are provided on at least one of the surface of the protrusion 31, the top wall of the first raised housing 221, the top wall of the second raised housing 211. When the screw is pressed, the circuit board 10, the shielding frame 21, the shielding cover 22, and the middle frame 30 can be ensured to be in tight contact, so that the electrical connection is stable and reliability is improved. In addition, due to existence of the contacts 33, when the screw is pressed, the screw may not be overtightened, thereby further avoiding causing damage by pressing the circuit board 10, reducing production losses of the electronic device 100, and improving a yield rate of a product.

Optionally, the plurality of contact points 33 for abutting are provided on the surface of the protrusion 31, the top wall of the first raised housing 221, the top wall of the second raised housing 211.

Optionally, the plurality of contact points 33 for abutting are provided on two of the surface of the protrusion 31, the top wall of the first raised housing 221, the top wall of the second raised housing 211.

Optionally, the plurality of contact points 33 for abutting are provided on one of the surface of the protrusion 31, the top wall of the first raised housing 221, the top wall of the second raised housing 211.

The top walls of the first raised housing 221 and the second raised housing 211 are both provided with an upper side surface and a lower side surface. A plurality of contact points 33 for abutting are provided on the top walls. This means that plurality of contact points 33 for abutting are provided on the upper side surfaces of the top walls and/or the lower side surfaces of the top walls.

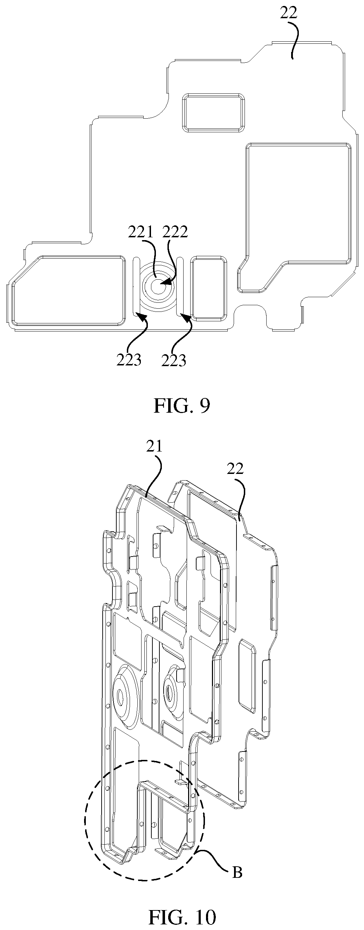

FIG. 8 is a schematic diagram of an example of a shielding frame 21 according to an embodiment of this application. FIG. 9 is a schematic diagram of an example of a shielding cover 22 according to an embodiment of this application.

As shown in FIG. 8 and FIG. 9, in an embodiment, a crack arrest groove 223 for stress relief is provided in an area that is on the shielding cover 22 and that is adjacent to the third hole 222 and/or an area that is on the shielding frame 21 and that is adjacent to the fourth hole 212.

In this embodiment, the crack arrest groove (223) is provided in the area that is on the shielding cover 22 and that is adjacent to the third hole 222 and/or the area that is on the shielding frame 21 and that is adjacent to the fourth hole 212. There are two main functions. First, in a process of processing the shielding cover 22 and the shielding frame 21, the crack arrest groove 223 is configured to prevent materials of the first raised housing 221 and the second raised housing 211 from being torn and deformed during a forming process, to prevent burrs and safety problems. Second, when the first raised housing 221 and the second raised housing 211 are sandwiched and squeezed by the protrusion 31 and the circuit board 10 by using the screw during a fastening process, deforming of structures of the shielding cover 22 and the shielding frame 21 is avoided during an assembly stage.

Optionally, a width of the crack arrest groove 223 is 1 to 1.5 times greater than a thickness of the shielding cover 22 or the shielding frame 21.

Optionally, a length of the crack arrest groove 223 is greater than lengths of the first raised housing 221 and the second raised housing 211. For example, if shapes of the first raised housing 221 and the second raised housing 211 are rectangular, the length of the crack arrest groove 223 is greater than long sides of the first raised housing 221 and the second raised housing 211. If the shapes of the first raised housing 221 and the second raised housing 211 are circular, the length of the crack arrest groove 223 is greater than diameters of the first raised housing 221 and the second raised housing 211. If the shapes of the first raised housing 221 and the second raised housing 211 are elliptical, the length of the crack arrest groove 223 is greater than major axes of the first raised housing 221 and the second raised housing 211.

It should be noted that the length and the width of the crack arrest groove 223 should not be too large, to ensure that radiation leakage of radio frequency is reduced and a shielding function of the shielding frame 21 is met.

In an embodiment, the shielding cover 22 detachably covers the shielding frame 21.

In this embodiment, the shielding frame 21 includes a shielding cover 22 and the shielding frame 21. The shielding cover 22 is fixed on the shielding frame 21 by a detachable structure. When a function of an internal electronic element 11 shielded by the shielding frame 21 is abnormal, the shielding cover 22 may be easily detached, to check a condition of the internal electronic element 11 and facilitate maintenance.

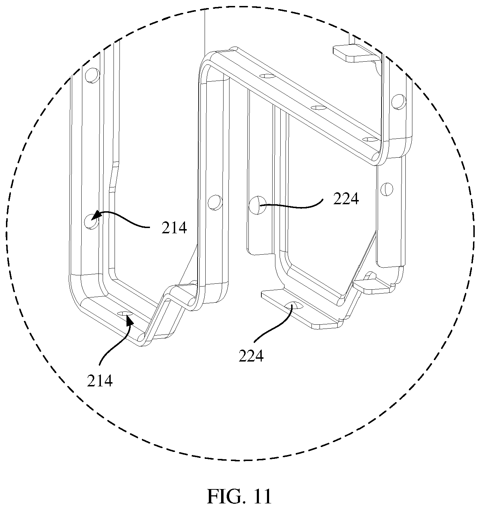

FIG. 10 is a schematic diagram of another example of a shielding cover 22 and a shielding frame 21 according to an embodiment of this application. FIG. 11 is an enlarged view of section B in FIG. 10.

As shown in FIG. 10 and FIG. 11, in an embodiment, a flange of the shielding cover 22 has bosses 224 arranged at intervals. Snap holes 214 are formed in peripheral walls of the shielding frame 21 corresponding to the bosses 224. The bosses 224 may be snapped into the snap holes 214, to enable the shielding cover 22 to be connected to the shielding frame 21.

This embodiment specifically describes a detachable connection structure of the shielding cover 22 and the shielding frame 21. The bosses 224 are arranged at intervals on the flange of the shielding cover 22. The snap holes 214 are formed in peripheral walls of the shielding frame 21 corresponding to the bosses 224. The bosses 224 can cooperate with the snap holes 214. During assembly, the shielding cover 22 is pressed toward the shielding frame 21. The bosses 224 may be snapped into the snap holes 214, thereby effectively fixing the shielding frame 21 and the shielding cover 22 together. During disassembly, the shielding cover 22 is pried up from the shielding frame 21 by using a flexible crowbar. The bosses 224 can slide out of the snap holes 214, thereby quickly separating the shielding cover 22 from the shielding frame 21. The structure can ensure good contact between the shielding cover 22 and the shielding frame 21, and is easy to disassemble and assemble.

Optionally, surfaces of the shielding cover 22 and the shielding frame 21 are further coated with wave-absorbing materials, so that a shielding effect of electromagnetic wave signals of the shielding cover 22 and the shielding frame 21 after being coated with the wave-absorbing materials is better.

Specifically, wave-absorbing materials mainly include iron oxide wave-absorbing materials, metal powder wave-absorbing materials, nano wave-absorbing materials, and optically transparent wave-absorbing materials. A working principle of a wave-absorbing material is that the wave-absorbing material can absorb electromagnetic wave energy projected onto a surface of the wave-absorbing material, and convert the electromagnetic wave energy into heat energy or another energy through dielectric loss of the material. This can be used to avoid interference, absorbing electromagnetic waves, radiating, shielding, and the like. The wave-absorbing material has high adhesive strength for reliable installation, is non-conductive for safety, and has a good mechanical performance for easy cutting.

In an embodiment, the electronic device 100 is a phone, a tablet computer, a portable multimedia player, or a handheld game console.

Optionally, the portable multimedia player may be a music player or a video player.

Optionally, the electronic device 100 in this application may be a phone. The circuit board 10 is securely connected to the middle frame 30 by the phone, and the shielding frame 21 is sandwiched between the middle frame 30 and the circuit board 10, so that the middle frame 30 is directly electrically connected to the circuit board 10 by the shielding frame 21 to implement grounding. Therefore, there is no need to use an elastic conductive member. This avoids considering accommodation space of the elastic conductive member in a structural design phase, to enable the phone to meet a design requirement of ultra-thinness. In addition, the phone does not need additional elastic conductive members such as a conductive foam, a conductive rubber, and a metal elastic piece. This can reduce purchasing and processing costs of the elastic conductive members, thereby reducing overall production costs of the phone.

The accommodation space of the elastic conductive member is reduced, a size requirement for internal space of the phone is lowered, so that the phone can meet the design requirement of ultra-thinness. Alternatively, without changing a thickness of the phone, the accommodation space reduced by the elastic conductive member can be provided for another functional element, so that a structural design of the phone is more flexible and diverse, thereby facilitating structural optimization.

Static electricity accumulated on a circuit board 10 of the phone may be discharged through a path formed by the circuit board 10, the shielding frame 21, and the middle frame 30. This can ensure that the static electricity of the circuit board 10 is not accumulated, thereby avoiding affecting circuits and electronic elements 11. In addition, when the electronic element 11 radiates and couples an electromagnetic signal by using the circuit board 10 to the shielding frame 21, the shielding frame 21 may conduct the electromagnetic signal to the middle frame 30, so that a residual electromagnetic signal that is parasitic on the shielding frame 21 is reduced, and electromagnetic interference to an external electronic element 11 and another component is reduced.

In an embodiment, the circuit board 10 is a main board. The electronic element 11 includes a central processing unit, a storage module, a power supply module, and a wireless communication module.

Usually, the power module exists on the circuit board 10 as a heat source and an interference source. A shielding frame 21 or an assembly of a shielding frame 21 and a shielding cover 22 is added to the power module. This can effectively reduce external radiation interference of the power module.

The central processing unit and the storage module are a core part of the circuit board 10, and stable and uninterrupted operation is a key for normal use of the electronic device 100. The central processing unit and the storage module are also electronic elements 11 that are susceptible to external interference, so that the shielding frame 21 or the assembly of the shielding frame 21 and the shielding cover 22 also needs to be disposed.

The wireless communication module mainly includes a wireless fidelity (Wireless Fidelity, Wi-Fi) module and a Bluetooth module. When receiving a signal, the wireless communication module is interfered with by another electronic element 11 on the circuit board 10. When sending a signal, the wireless communication module also causes strong interference to another electronic element 11. Therefore, the shielding frame 21 or the assembly of the shielding frame 21 and the shielding cover 22 needs to be disposed. In addition, a position of the wireless communication module is also very important. The wireless communication module is generally placed in an edge of the circuit board 10 and an area with a low density of electronic elements 11.

Finally, it should be noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An electronic device, comprising:
a circuit board (10), provided with an electronic element (11);
a shielding frame (21), wherein the shielding frame is disposed on the circuit board (10), and surrounds the electronic element (11);
a middle frame (30), wherein the middle frame is securely connected to the circuit board (10) by a screw (50), and the shielding frame (21) is sandwiched between the middle frame (30) and the circuit board (10), to enable the middle frame (30), the shielding frame (21), and the circuit board (10) to be electrically connected;
wherein the screw (50) sequentially passes through the circuit board (10) and the shielding frame (21), and is connected to the middle frame (30);
a first hole (12) is formed in the circuit board (10), the middle frame (30) has a protrusion (31) formed by the middle frame (30) extending toward the circuit board (10), a second hole (32) having a hole wall provided with an internal thread is formed in a surface of the protrusion (31), and the screw passes through the first hole (12) and is screwed into the second hole (32), to enable the middle frame (30) to be securely connected to the circuit board (10),
wherein the electronic device further comprises:
a shielding cover (22), wherein the shielding cover (22) is located between the middle frame (30) and the shielding frame (21), the shielding cover (22) has a first raised housing (221) bending toward the circuit board (10), a cavity of the first raised housing (221) is configured to accommodate the protrusion (31), a third hole (222) is formed in a top wall of the first raised housing (221),
wherein the screw sequentially passes through the first hole (12) and the third hole (222), and is screwed into the second hole (32), to enable the protrusion (31), the first raised housing (221), and the circuit board (10) to be sequentially abut against each other,
wherein the shielding frame (21) has a second raised housing (211) formed by the shielding frame (21) bending toward the circuit board (10), a cavity of the second raised housing (211) may accommodate the first raised housing (221), a fourth hole (212) is formed in a top wall of the second raised housing (211),
wherein a crack arrest groove (223) for stress relief is provided in an area on the shielding cover (22) adjacent to the third hole (222) and/or an area on the shielding frame (21) adjacent to the fourth hole (212).

2. The electronic device according to claim 1, wherein the screw sequentially passes through the first hole (12), the fourth hole (212), and the third hole (222), and is screwed into the second hole (32), to enable the protrusion (31), the first raised housing (221), the second raised housing (211), and the circuit board (10) to be sequentially abut against each other.

3. The electronic device according to claim 2, further comprising:
a pad portion (40), disposed between a head of the screw and the circuit board (10).

4. The electronic device according to claim 3, wherein the pad portion (40) comprises a base (42) and a bracket (43), a fifth hole (41) is formed in the base (42) and is located in a limiting groove (431) formed in the bracket (43).

5. The electronic device according to claim 4, wherein the screw sequentially passes through the fifth hole (41), the first hole (12), the fourth hole (212), and the third hole (222), and is screwed into the second hole (32), to enable the protrusion (31), the first raised housing (221), the second raised housing (211), the circuit board (10), and the base (42) to be sequentially abut against each other.

6. The electronic device according to any one of claims 1 to 5, wherein a plurality of contact points (33) for abutting are provided on at least one of the surface of the protrusion (31), the top wall of the first raised housing (221), and the top wall of the second raised housing (211).

7. The electronic device according to any one of claims 1 to 6, wherein the shielding cover (22) detachably covers the shielding frame (21).

8. The electronic device according to claim 7, wherein a flange of the shielding cover (22) has bosses (224) arranged at intervals, snap holes (214) are formed in peripheral walls of the shielding frame (21) corresponding to the bosses (224).

9. The electronic device according to claim 8, wherein the bosses (224) may be snapped into the snap holes (214), to enable the shielding cover (22) to be connected to the shielding frame (21).

10. The electronic device according to any one of claims 1 to 9, wherein the electronic device (100) is a phone, a tablet computer, a portable multimedia player, or a handheld game console.

11. The electronic device according to any one of claims 1 to 10, wherein the circuit board (10) is a main board, the electronic element (11) comprises a central processing unit, a storage module, a power supply module, and a wireless communication module, and the shielding frame (21) surrounds the central processing unit, the storage module, the power supply module, and the wireless communication module.

## Patentansprüche

1. Elektronisches Gerät, umfassend:
eine Leiterplatte (10), die mit einem elektronischen Bauelement (11) versehen ist;
einen Abschirmrahmen (21), wobei der Abschirmrahmen auf der Leiterplatte (10) angeordnet und das elektronische Bauelement (11) umgibt;
einen Mittelrahmen (30), wobei der Mittelrahmen mit der Leiterplatte (10) durch eine Schraube (50) fest verbunden ist und der Abschirmrahmen (21) zwischen dem Mittelrahmen (30) und der Leiterplatte (10) eingespannt ist, sodass der Mittelrahmen (30), der Abschirmrahmen (21) und die Leiterplatte (10) elektrisch miteinander verbunden sind;
wobei die Schraube (50) der Reihe nach durch die Leiterplatte (10) und den Abschirmrahmen (21) hindurchgeführt und mit dem Mittelrahmen (30) verbunden ist;
wobei ein erstes Loch (12) in der Leiterplatte (10) ausgebildet ist, der Mittelrahmen (30) einen Vorsprung (31) aufweist, der durch den Mittelrahmen (30) in Richtung der Leiterplatte (10) gebildet ist, in einer Oberfläche des Vorsprungs (31) ein zweites Loch (32) mit einer Innengewinde-Lochwand angeordnet ist, und die Schraube das erste Loch (12) durchdringt und in das zweite Loch (32) eingeschraubt wird, um den Mittelrahmen (30) fest mit der Leiterplatte (10) zu verbinden,
wobei das elektronische Gerät ferner umfasst:
eine Abschirmabdeckung (22), wobei die Abschirmabdeckung (22) zwischen dem Mittelrahmen (30) und dem Abschirmrahmen (21) angeordnet ist, die Abschirmabdeckung (22) ein erstes erhöhtes Gehäuse (221) aufweist, das sich zur Leiterplatte (10) hin biegt, ein Hohlraum des ersten erhöhten Gehäuses (221) zur Aufnahme des Vorsprungs (31) ausgelegt ist, ein drittes Loch (222) in einer oberen Wand des ersten erhöhten Gehäuses (221) ausgebildet ist,
wobei die Schraube der Reihe nach durch das erste Loch (12) und das dritte Loch (222) geführt und in das zweite Loch (32) eingeschraubt wird, sodass der Vorsprung (31), das erste erhöhte Gehäuse (221) und die Leiterplatte (10) nacheinander aneinander anliegen,
wobei der Abschirmrahmen (21) ein zweites erhöhtes Gehäuse (211) aufweist, das durch Biegevorgang des Abschirmrahmens (21) zur Leiterplatte (10) hin ausgebildet ist, ein Hohlraum des zweiten erhöhten Gehäuses (211) das erste erhöhte Gehäuse (221) aufnehmen kann und ein viertes Loch (212) in einer oberen Wand des zweiten erhöhten Gehäuses (211) ausgebildet ist,
wobei eine Rissstoppnut (223) zur Spannungsentlastung in einem Bereich der Abschirmabdeckung (22) benachbart zum dritten Loch (222) und/oder in einem Bereich des Abschirmrahmens (21) benachbart zum vierten Loch (212) vorgesehen ist.

2. Elektronisches Gerät nach Anspruch 1, wobei die Schraube nacheinander durch das erste Loch (12), das vierte Loch (212) und das dritte Loch (222) geführt wird und in das zweite Loch (32) eingeschraubt wird, sodass die Ausbuchtung (31), das erste erhöhte Gehäuse (221), das zweite erhöhte Gehäuse (211) und die Leiterplatte (10) nacheinander aneinander anliegen.

3. Elektronisches Gerät nach Anspruch 2, weiterhin umfassend:
einen Polsterbereich (40), der zwischen einem Schraubenkopf und der Leiterplatte (10) angebracht ist.

4. Elektronisches Gerät nach Anspruch 3, wobei der Polsterbereich (40) eine Basis (42) und eine Halterung (43) umfasst, wobei ein fünftes Loch (41) in der Basis (42) ausgebildet ist und sich in einer Begrenzungsnut (431) befindet, die in der Halterung (43) gebildet ist.

5. Elektronisches Gerät nach Anspruch 4, wobei die Schraube nacheinander durch das fünfte Loch (41), das erste Loch (12), das vierte Loch (212) und das dritte Loch (222) geführt wird und in das zweite Loch (32) eingeschraubt wird, sodass die Ausbuchtung (31), das erste erhöhte Gehäuse (221), das zweite erhöhte Gehäuse (211), die Leiterplatte (10) und die Basis (42) nacheinander aneinander anliegen.

6. Elektronisches Gerät nach einem der Ansprüche 1 bis 5, wobei auf mindestens einer der Oberflächen der Ausbuchtung (31), der oberen Wand des ersten erhöhten Gehäuses (221) und der oberen Wand des zweiten erhöhten Gehäuses (211) mehrere Kontaktpunkte (33) zum Anliegen vorgesehen sind.

7. Elektronisches Gerät nach einem der Ansprüche 1 bis 6, wobei die Abschirmabdeckung (22) abnehmbar die Abschirmrahmen (21) bedeckt.

8. Elektronisches Gerät nach Anspruch 7, wobei ein Flansch der Abschirmabdeckung (22) mit in Abständen angeordneten Vorsprüngen (224) versehen ist, und an den Seitenwänden des Abschirmrahmens (21), die den Vorsprüngen (224) entsprechen, Schnappöffnungen (214) ausgebildet sind.

9. Elektronisches Gerät nach Anspruch 8, wobei die Vorsprünge (224) in die Schnappöffnungen (214) einrasten können, sodass die Abschirmabdeckung (22) mit dem Abschirmrahmen (21) verbunden werden kann.

10. Elektronisches Gerät nach einem der Ansprüche 1 bis 9, wobei das elektronische Gerät (100) ein Telefon, ein Tablet-Computer, ein tragbarer Multimedia-Player oder eine tragbare Spielkonsole ist.

11. Elektronisches Gerät nach einem der Ansprüche 1 bis 10, wobei die Leiterplatte (10) eine Hauptplatine ist, die elektronische Komponente (11) eine zentrale Verarbeitungseinheit, ein Speichermodul, ein Stromversorgungsmodul und ein drahtloses Kommunikationsmodul umfasst, und der Abschirmrahmen (21) die zentrale Verarbeitungseinheit, das Speichermodul, das Stromversorgungsmodul und das drahtlose Kommunikationsmodul umgibt.

## Revendications

1. Un dispositif électronique, comprenant :
une carte de circuit imprimé (10), pourvue d'un élément électronique (11) ;
un cadre de blindage (21), le cadre de blindage étant disposé sur la carte de circuit imprimé (10) et entourant l'élément électronique (11) ;
un châssis intermédiaire (30), le châssis intermédiaire étant fixé de manière sécurisée à la carte de circuit imprimé (10) par une vis (50), le cadre de blindage (21) étant pris en sandwich entre le châssis intermédiaire (30) et la carte de circuit imprimé (10), afin de permettre au châssis intermédiaire (30), au cadre de blindage (21) et à la carte de circuit imprimé (10) d'être reliés électriquement ;
la vis (50) traverse successivement la carte de circuit imprimé (10) et le cadre de blindage (21), et est reliée au châssis intermédiaire (30) ;
un premier trou (12) est formé dans la carte de circuit imprimé (10), le châssis intermédiaire (30) comporte une saillie (31) formée par l'extension du châssis intermédiaire (30) vers la carte de circuit imprimé (10), un deuxième trou (32) dont la paroi est munie d'un filetage interne est aménagé à la surface de la saillie (31), et la vis traverse le premier trou (12) et est vissée dans le deuxième trou (32), permettant ainsi la fixation sécurisée du châssis intermédiaire (30) à la carte de circuit imprimé (10),
le dispositif électronique comprenant en outre :
un couvercle de blindage (22), le couvercle de blindage (22) étant situé entre le châssis intermédiaire (30) et le cadre de blindage (21), le couvercle de blindage (22) comportant un premier boîtier surélevé (221) courbé vers la carte de circuit imprimé (10), la cavité du premier boîtier surélevé (221) étant conçue pour accueillir la saillie (31), un troisième trou (222) est formé dans la paroi supérieure du premier boîtier surélevé (221),
la vis traverse successivement le premier trou (12) et le troisième trou (222), et est vissée dans le deuxième trou (32), de manière à ce que la saillie (31), le premier boîtier surélevé (221) et la carte de circuit imprimé (10) soient successivement en contact mutuel,
le cadre de blindage (21) comportant un deuxième boîtier surélevé (211), formé par le cadre de blindage (21) courbé vers la carte de circuit imprimé (10), la cavité du deuxième boîtier surélevé (211) pouvant accueillir le premier boîtier surélevé (221), un quatrième trou (212) étant formé dans la paroi supérieure du deuxième boîtier surélevé (211),
une rainure d'arrêt de fissure (223) pour la libération de contraintes étant prévue dans une zone du couvercle de blindage (22) adjacente au troisième trou (222) et/ou dans une zone du cadre de blindage (21) adjacente au quatrième trou (212).

2. Dispositif électronique selon la revendication 1, dans lequel la vis traverse successivement le premier trou (12), le quatrième trou (212) et le troisième trou (222), puis est vissée dans le deuxième trou (32), de sorte que la saillie (31), le premier boîtier surélevé (221), le second boîtier surélevé (211) et la carte de circuit imprimé (10) viennent successivement en butée les uns contre les autres.

3. Dispositif électronique selon la revendication 2, comprenant en outre :
une partie tampon (40), disposée entre la tête de la vis et la carte de circuit imprimé (10).

4. Dispositif électronique selon la revendication 3, dans lequel la partie tampon (40) comprend une base (42) et un support (43), un cinquième trou (41) est formé dans la base (42) et est situé dans une rainure de limitation (431) formée dans le support (43).

5. Dispositif électronique selon la revendication 4, dans lequel la vis traverse successivement le cinquième trou (41), le premier trou (12), le quatrième trou (212) et le troisième trou (222), puis est vissée dans le deuxième trou (32), de sorte que la saillie (31), le premier boîtier surélevé (221), le second boîtier surélevé (211), la carte de circuit imprimé (10) et la base (42) viennent successivement en butée les uns contre les autres.

6. Dispositif électronique selon l'une quelconque des revendications 1 à 5, dans lequel une pluralité de points de contact (33) pour la butée sont aménagés sur au moins l'une des surfaces suivantes : la surface de la saillie (31), la paroi supérieure du premier boîtier surélevé (221) et la paroi supérieure du second boîtier surélevé (211).

7. Dispositif électronique selon l'une quelconque des revendications 1 à 6, dans lequel le couvercle de blindage (22) recouvre amovible le cadre de blindage (21).

8. Dispositif électronique selon la revendication 7, dans lequel une bride du couvercle de blindage (22) présente des bossages (224) disposés à intervalles, des trous de verrouillage (214) étant formés dans les parois périphériques du cadre de blindage (21) en face des bossages (224).

9. Dispositif électronique selon la revendication 8, dans lequel les bossages (224) peuvent être encliquetés dans les trous de verrouillage (214), de sorte que le couvercle de blindage (22) soit relié au cadre de blindage (21).

10. Dispositif électronique selon l'une quelconque des revendications 1 à 9, dans lequel le dispositif électronique (100) est un téléphone, une tablette, un lecteur multimédia portable ou une console de jeux portable.

11. Dispositif électronique selon l'une quelconque des revendications 1 à 10, dans lequel la carte de circuit imprimé (10) est une carte mère, l'élément électronique (11) comprend un processeur central, un module de stockage, un module d'alimentation et un module de communication sans fil, et le cadre de blindage (21) entoure le processeur central, le module de stockage, le module d'alimentation et le module de communication sans fil.
